# EUROPÄISCHE PATENTSCHRIFT

(11) **EP 2 197 115 B1**
(45) Veröffentlichungstag und Bekanntmachung des Hinweises auf die Patenterteilung: **25.04.2012**
(21) Anmeldenummer: 09014941.0
(22) Anmeldetag: 02.12.2009
(51) Int. Cl.: H03K 17/96

(54) **Bedienvorrichtung mit wenigstens einem Druckschalter**
Operating device with at least one pressure switch
Dispositif de commande doté d'au moins un interrupteur à pression

(30) Priorität: 13.12.2008 DE 102008062216
(43) Veröffentlichungstag der Anmeldung: 16.06.2010
(73) Patentinhaber: Diehl AKO Stiftung & Co. KG, 88239 Wangen (DE)
(72) Erfinder: Heimann, Uwe, 88239 Wangen (DE)
(74) Vertreter: Diehl Patentabteilung

(56) Entgegenhaltungen:
- WO-A1-96/20533
- DE-A1-102004 052 501

## Beschreibung

Die vorliegende Erfindung betrifft eine Bedienvorrichtung mit mehreren Drucktastschaltern, wie sie beispielsweise in einer Bedienblende für ein elektronisches Haushaltsgerät eingesetzt werden kann.

Es sind Drucktastschalter bekannt, welche den Piezoeffekt ausnutzen. Solche Drucktastschalter enthalten ein piezoelektrisches Element, das zwischen zwei Elektroden angeordnet ist. Beim Ausüben eines Drucks bzw. einer Kraft auf das piezoelektrische Element wird an den beiden Elektroden eine Ladung freigesetzt, die proportional zur ausgeübten Kraft ist. Über die Messung dieser Ladung kann so eine Betätigung des Drucktastschalters festgestellt werden, wobei der notwendige Betätigungsweg sehr gering ist.

Die Verwendung derartiger Drucktastschalter mit einem druckempfindlichen Übertragungselement hat einige Vorteile im Vergleich zu herkömmlichen Tastschaltern. Aufgrund der minimalen Betätigungswege entsteht kein Verschleiß von mechanisch beweglichen Teilen und ist ein einfacher und mechanisch robuster Aufbau des Tastschalters möglich. Weiter sind in den zugehörigen Bedienblenden zum Beispiel der elektronischen Haushaltsgeräte keine Durchbrüche oder Erhebungen bzw. Vertiefungen notwendig, weshalb der Drucktastschalter feuchtigkeitsdicht angeordnet ist und die Bedienblende einfach gereinigt werden kann.

Als druckempfindliches Übertragungselement für einen solchen Drucktastschalter ist es aus dem Stand der Technik bekannt, zum Beispiel eine so genannte Piezofolie einzusetzen. Bei einer Piezofolie wird auf einer Kunststofffolie in mehreren Schritten zum Beispiel im Siebdruck ein piezoelektrischer Schichtaufbau hergestellt, wobei die Piezokristalle beispielsweise in Form eines Piezolackes aufgedruckt werden. Die Elektroden, über welche die von den Piezokristallen erzeugte elektrische Ladung abgegriffen wird, werden dabei zwischen den Schichten des Mehrschichtaufbaus zum Beispiel durch Aufdrucken angeordnet.

Bei elektronischen Haushaltsgeräten und dergleichen besteht Bedarf an einer sehr kompakten und montagefreundlichen Bedienvorrichtung, die außerdem einen möglichst hohen Integrationsgrad besitzen soll.

Die EP 0 502 452 A1 offenbart eine piezoelektrische Tastatur, bei welcher zwischen der Piezofolie und der transparenten Frontplatte eine Lichtemitterfolie angeordnet ist, welche mit den beiden angrenzenden Komponenten jeweils über eine Overlaykleberschicht verbunden ist.

Bei den herkömmlichen Bedienvorrichtungen dieser Art ist die Piezofolie üblicherweise über eine harte und unnachgiebige Klebeschicht mit der Deckschicht verbunden, um eine sichere Übertragung auch sehr kleiner Betätigungswege von der Deckschicht auf die darunter liegende Piezofolie zu gewährleisten. Nachteilig an diesem Aufbau sind die Verformungsprobleme der Bedienvorrichtung unter Temperatur- und Feuchteeinfluss, die durch die unterschiedlichen Wärmeausdehnungskomponenten der Materialien von Deckschicht und Piezofolie entstehen.

Die Anmelderin hat daher bereits in der DE 10 2007 054 778 A1 eine Bedienvorrichtung vorgeschlagen, bei welcher die Klebeschicht zwischen Deckschicht und Piezofolie weich ausgebildet ist und zwischen der Deckschicht und dem Sensorfeld der Piezofolie innerhalb eines von der Klebeschicht ausgesparten Raums ein Kraftübertragungselement zum Beispiel in Form eines mit der Deckschicht verbundenen Stößels angeordnet ist. Während die nachgiebige Klebeschicht die unterschiedlichen Wärmeausdehnungen der benachbarten Komponenten kompensiert bzw. ausgleicht, gewährleistet das starre Kraftübertragungselement auch die Übertragung sehr kleiner Betätigungswege von der Deckschicht auf die Piezofolie.

Aus der DE 10 2004 052 501 A1 ist ein piezoelektrisches Bedienelement bekannt, bei welchem das Piezoelement, welches das Sensorfeld bildet, über eine thermische Isolierschicht in Form einer transparenten Acrylatkleberschicht mit der Deckschicht verbunden ist. In einer vorgeschlagenen Ausgestaltung sind mehrere solcher piezoelektrischer Bedienelemente zu einem gemeinsamen Bedienfeld zusammengefasst, wobei die gemeinsame Kleberschicht des Bedienfeldes in erste Bereiche, die über den einzelnen piezoelektrischen Bedienelementen liegen, und einen zweiten Bereich, der den Rest der Kleberschicht bildet, unterteilt ist.

Der vorliegenden Erfindung liegt die Aufgabe zugrunde, eine Bedienvorrichtung mit mehreren Drucktastschaltern vorzusehen, die eine gute thermische Funktionsstabilität besitzt.

Diese Aufgabe wird gelöst durch eine Bedienvorrichtung mit den Merkmalen des Anspruchs 1. Vorteilhafte Ausgestaltungen und Weiterbildungen der Erfindung sind Gegenstand der abhängigen Ansprüche.

Die Bedienvorrichtung mit mehreren Drucktastschaltern gemäß der Erfindung weist ein Trägerelement, ein druckempfindliches Übertragungselement mit mehreren Sensorfeldern entsprechend den Drucktastschaltern, wobei das Übertragungselement mit dem Trägerelement über eine erste Klebeschicht verbunden ist, und eine der Benutzerseite zugewandte Deckschicht auf. Die Deckschicht ist über eine zweite Klebeschicht mit dem Übertragungselement verbunden, wobei diese zweite Klebeschicht weich ausgebildet ist und im Bereich der Sensorfelder des Ubertragungselements jeweils einen Klebeschichtbereich aufweist, der kleiner als das jeweilige Sensorfeld bemessen ist und über wenigstens eine Aussparung im Bereich des jeweiligen Sensorfeldes von der übrigen zweiten Klebeschicht wenigstens teilweise getrennt ist.

Der Aufbau dieser Bedienvorrichtung mit Trägerelement, Übertragungselement und Deckschicht stellt eine sehr flache Bauweise dar. Die Bedienvorrichtung dieses Aufbaus kann vorgefertigt werden und so auf einfache Weise als eine Baueinheit zum Beispiel in einer Bedienblende eines elektronischen Haushaltsgeräts montiert werden.

Die Übertragung des von einem Finger auf die Deckschicht der Bedienvorrichtung aufgebrachten Drucks auf das Übertragungselement erfordert eigentlich eine steife und unnachgiebige Flächenverbindung zwischen diesen beiden Elementen. Aufgrund der im Allgemeinen unterschiedlichen Wärmeausdehnungskoeffizienten der für diese Elemente verwendeten Materialien kann es aber zu einer wärmeabhängigen Verspannung bzw. Verformung und unter Umständen sogar zu einer Beschädigung des konstruktiven Aufbaus kommen. Bei der Verwendung einer weichen bzw. nachgiebigen zweiten Klebeschicht zwischen dem Übertragungselement und der Deckschicht können diese unterschiedlichen Wärmeausdehnungen der miteinander verbundenen Komponenten kompensiert bzw. vermindert werden.

Um trotz dieser weichen Klebeverbindung die kleinen bzw. sehr kleinen Betätigungswege von der Deckschicht auf das Übertragungselement übertragen zu können, ist die zweite Klebeschicht derart ausgebildet, dass sie im Bereich der Sensorfelder des Übertragungselements jeweils einen Klebeschichtbereich aufweist, der kleiner als das jeweilige Sensorfeld bemessen ist und über wenigstens eine Aussparung von der übrigen zweiten Klebeschicht wenigstens teilweise getrennt ist. Die klebefreie Aussparung um den Sensorfeld-Klebeschichtbereich herum vermindert die dämpfende Wirkung der Klebeschicht, sodass die Wegübertragungen direkter erfolgen können. Ein separates, starr bzw. unnachgiebig ausgebildetes Kraft- bzw. Wegübertragungselement ist deshalb bei der erfindungsgemäßen Ausgestaltung der zweiten Klebeschicht nicht erforderlich.

Außerdem ist die Deckschicht über den mittigen Klebeschichtbereich der zweiten Klebeschicht unmittelbar mit dem jeweiligen Sensorfeld des Übertragungselements verbunden, sodass das Übertragungselement direkt und beidseitig dem Betätigungsweg der Deckschicht folgen kann. Die Wegübertragung ist damit unabhängig von einer Vorspannung des Übertragungselements.

In einer Ausführungsform der erfindungsgemäßen Bedienvorrichtung kann der Sensorfeld-Klebeschichtbereich im Wesentlichen mittig zum jeweilige n a Sensorfeld des darunter liegenden Übertragungselements angeordnet sein und/oder kann die wenigstens eine Aussparung der zweiten Klebeschicht den Sensorfeld-Klebeschichtbereich im Wesentlichen ringförmig umgeben.

In einer Ausgestaltung der Erfindung weist das Trägerelement auf seiner dem Übertragungselement abgewandten Seite eine Aussparung auf und die Bedienvorrichtung ist ferner mit einer Leiterplatte versehen, die in die Aussparung des Trägerelements eingesetzt ist, vorzugsweise darin im Wesentlichen vollständig aufgenommen ist. Hierdurch ist eine extrem flache Konstruktion der Bedienvorrichtung einschließlich Leiterplatte ermöglicht.

In einer weiteren Ausgestaltung der Erfindung kann die Bedienvorrichtung wenigstens ein Befestigungselement zum Befestigen der Bedienvorrichtung an einer Bedienblende aufweisen. Dieses wenigstens eine Befestigungselement enthält zum Beispiel eine dritte Klebeschicht und/oder eine Rastvorrichtung.

In einer noch weiteren Ausgestaltung der Erfindung weist die Bedienvorrichtung ferner wenigstens ein Anzeigeelement (Leuchtdiode, Display) auf, das ebenfalls in kompakter und flacher Bauweise in dem Trägerelement integriert ist.

In einer bevorzugten vorteilhaften Alternative ist das druckempfindliche Übertragungselement der Bedieneinrichtung ein Piezoelement, eine Piezo(Sensor)folie oder ein Dehnungsmessstreifen. Die Bedienvorrichtung enthält dabei vorzugsweise eine Vielzahl von auf dem Piezoeffekt oder auf dem Dehnungsmessprinzip beruhenden Drucktastschaltern. In einer besonderen Ausgestaltung ist auch eine Verwendung unterschiedlicher Übertragungselemente in einer Bedieneinrichtung möglich.

Die oben beschriebene Bedienvorrichtung der Erfindung ist in besonders vorteilhafter Weise in einer Bedienblende für ein elektronisches Haushaltsgerät einsetzbar, ohne dass die Erfindung auf diese Anwendung beschränkt sein soll.

Obige sowie weitere Merkmale und Vorteile der Erfindung werden aus der nachfolgenden Beschreibung eines bevorzugten, nicht-einschränkenden Ausführungsbeispiels unter Bezug auf die beiliegenden Zeichnungen besser verständlich. Darin zeigen:
- Fig. 1: eine schematische Perspektivansicht einer in eine Bedienblende ein- gesetzten Bedienvorrichtung der Erfindung;
- Fig. 2: eine perspektivische Explosionsdarstellung einer Bedienvorrichtung gemäß einem Ausführungsbeispiel der Erfindung;
- Fig. 3: eine schematische Teilschnittansicht der Bedienvorrichtung von Fig. 2 im montierten Zustand;
- Fig. 4: eine schematische Teilschnittansicht der Bedienvorrichtung von Fig. 2 im montierten Zustand; und
- Fig. 5: eine schematische Draufsicht einer zweiten Klebeschicht der Bedien- vorrichtung von Fig. 2.

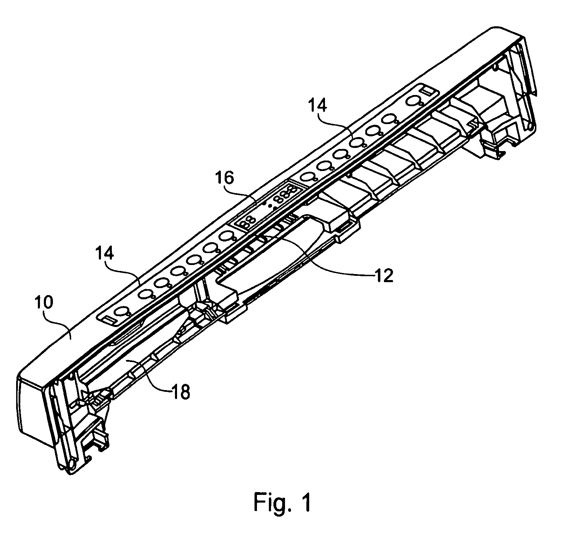

Fig. 1 zeigt beispielhaft eine Bedienblende 10 für ein elektronisches Haushaltsgerät (zum Beispiel Herd, Kochfeld, Waschmaschine, Trockner, Spülmaschine, usw.), ohne dass die Erfindung auf diese Anwendung beschränkt sein soll.

Auf der dem Benutzer zugewandten Seite (oben in Fig. 1) hat die Bedienblende 10 eine Aussparung, in welche eine Bedienvorrichtung (bzw. Bedien- und Anzeigevorrichtung oder Eingabe/Ausgabe-Vorrichtung) 12 eingesetzt ist, welche zwei Eingabebereiche 14 mit jeweils mehreren Drucktastschaltern und einen zentralen Anzeigebereich 16 aufweist. In Fig. 1 ist außerdem eine elektronische Steuerung 18 des Haushaltsgeräts erkennbar, welche mit der Bedienvorrichtung 12 über ein entsprechendes Verbindungskabel (nicht dargestellt) verbunden ist.

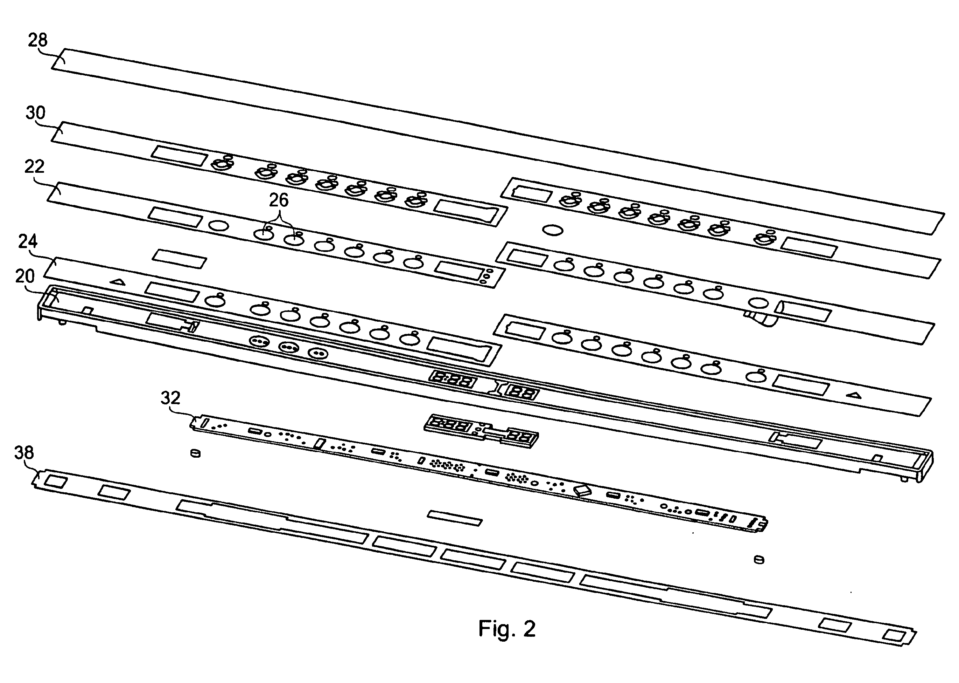

Es wird nun Bezug nehmend auf Fig. 2 bis 5 ein Ausführungsbeispiel einer erfindungsgemäßen Bedienvorrichtung 12 näher beschrieben. Im Vergleich zu dem in Fig. 1 dargestellten Grundaufbau weist dieses Ausführungsbeispiel keinen Anzeigebereich 16 auf. Selbstverständlich kann die in Fig. 2 bis 5 gezeigte Bedienvorrichtung 12 aber problemlos um einen solchen Anzeigebereich 16 mit einem entsprechenden Anzeigeelement ergänzt werden.

Die Bedienvorrichtung 12 enthält ein Trägerelement 20 zum Beispiel aus Kunststoff (z.B. PMMA), dessen Maße im Wesentlichen die Größe der Bedienvorrichtung 12 bestimmen. Auf der dem Benutzer zugewandten Seite (oben in Fig. 2) des Trägerelements 20 sind in zwei Eingabebereichen 14 der Bedienvorrichtung 12 zwei Piezo(sensor)folien 22 angeordnet, welche über eine erste Klebeschicht 24 mit dem Trägerelement 20 verbunden sind. Diese erste Klebeschicht 24 bildet üblicherweise eine nachgiebige und weiche Flächenverbindung zwischen dem Trägerelement 20 und den Piezofolien 22.

Als Piezofolien 22 können grundsätzlich beliebige Piezofolien benutzt werden; die Erfindung ist auf keine spezielle Art eingeschränkt. Bei den Piezofolien 22 handelt es sich jeweils um ein mehrschichtiges piezoelektrisches Element, das bei Ausübung eines Drucks oder einer Kraft eine an den Elektroden messbare Spannung erzeugt, wie bereits in der Beschreibungseinleitung erläutert. Die Piezofolien 22 besitzen jeweils mehrere Sensorfelder 26, die in Anzahl und Anordnung den gewünschten Drucktastschaltern der Bedienvorrichtung 12 entsprechen.

Alternativ zur Piezofolie 22 kann auch ein Dehnungsmessstreifen 22 oder eine Kombination aus Piezofolie 22 und Dehnungsmessstreifen 22 eingesetzt werden.

Auf der dem Benutzer zugewandten Seite (oben in Fig. 2) der Piezofolien 22 ist eine Deckschicht 28 vorgesehen, die mit den beiden Piezofolien 22 jeweils über eine zweite Klebeschicht 30 verbunden ist. Die Deckschicht 28 ist in der Form einer Folie zum Beispiel aus Metall gebildet und dient einerseits als Betätigungsfläche, die vom Benutzer mit Druck beaufschlagt werden kann, um einen entsprechenden Drucktastschalter an der Position eines Sensorfeldes 26 der Piezofolie 22 zu betätigen, kennzeichnet für den Benutzer die einzelnen Drucktastschalter entsprechend den Positionen der Sensorfelder 26 der Piezofolien 22 und dient schließlich als Designelement der Bedienblende 10.

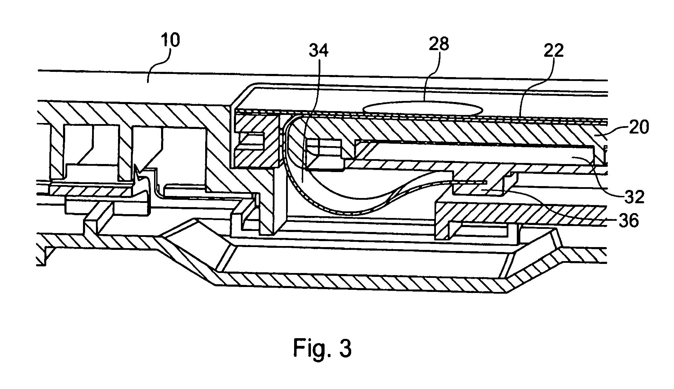

Weiter hat die Bedienvorrichtung 12 eine Leiterplatte 32 mit einer Auswerte- und Steuerelektronik der Bedienvorrichtung, die in eine Aussparung an der dem Benutzer abgewandten Seite (unten in Fig. 2) des Trägerelements 20 eingesetzt bzw. vorzugsweise im Wesentlichen vollständig aufgenommen ist. Üblicherweise ist die Leiterplatte 32 in die entsprechende Ausnehmung des Trägerelements 20 festgeklemmt oder wahlweise auch mit Klebepunkten fixiert. Wie in Fig. 3 veranschaulicht, sind die Piezofolien 22 jeweils über ein Verbindungskabel 34 mit einem entsprechenden Anschluss / Stecker 36 auf der Leiterplattenunterseite verbunden. Die Leiterplatte 32 ist wiederum über ein entsprechendes Verbindungskabel mit der elektronischen Steuerung 18 (nicht gezeigt in Fig. 3) verbunden, obwohl dies in den Figuren nicht dargestellt ist.

Durch den oben beschriebenen Schichtaufbau der Bedienvorrichtung 12 einschließlich Piezofolien 22 und Leiterplatte 32 steht eine Bedienvorrichtung mit einer extrem flachen Konstruktion und einem hohem Integrationsgrad zur Verfügung. Die Bedienvorrichtung 12 mit einer Vielzahl von Drucktastschaltern kann als eine Baueinheit vormontiert und dann in die Bedienblende 10 eingesetzt werden, was die Montage der Drucktastschalter wesentlich vereinfacht. Außerdem erfüllt die Bedienvorrichtung 12 gleichzeitig eine Designfunktion, wenn die Deckschicht(en) 28 entsprechend gestaltet ist bzw. sind.

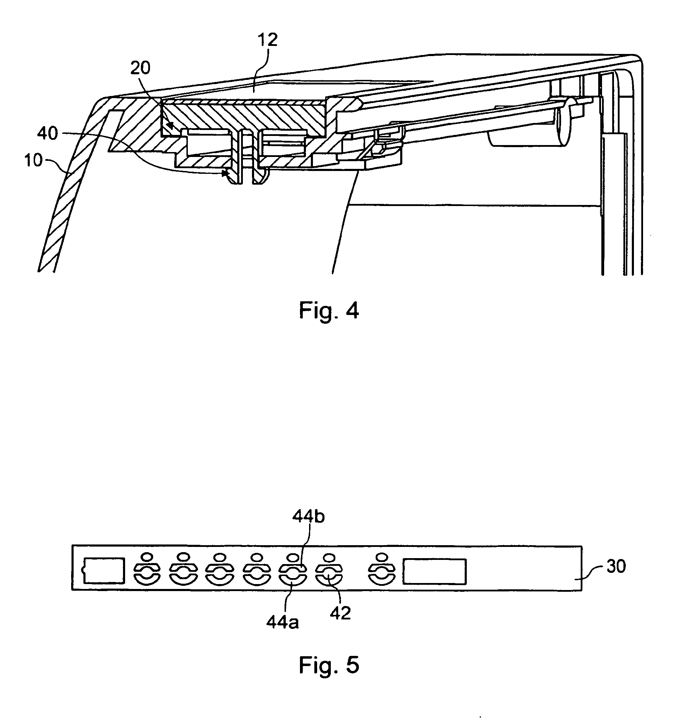

Zur Fixierung der vorgefertigten Bedienvorrichtung 12 in der Bedienblende 10 kann eine dritte Klebeschicht 38 auf der dem Benutzer abgewandten Seite der Bedienvorrichtung 12 vorgesehen sein (siehe Fig. 2). Alternativ oder zusätzlich ist das Trägerelement 20 mit wenigstens einer Rastvorrichtung 40 ausgebildet, mit welcher die Bedienvorrichtung 12 in entsprechende Rastausnehmungen der Bedienblende 10 eingerastet werden kann, wie in Fig. 4 dargestellt.

Wie oben erwähnt, sind die Piezofolien 22 über zweite Klebeschichten 30 direkt und fest mit der Deckschicht 28 verbunden. Im Gegensatz zu den herkömmlichen Bedienvorrichtungen dieser Art, sind diese zweiten Klebeschichten 30 nicht hart und unnachgiebig ausgebildet, sondern bilden gemäß der vorliegenden Erfindung stattdessen eine weiche und nachgiebige Flächenverbindung zwischen den beiden Komponenten.

Durch diese nachgiebige Verbindung zwischen Piezofolien 22 und Deckschicht 28 können in vorteilhafter Weise unterschiedliche Wärmeausdehnungen dieser beiden Komponenten der Bedienvorrichtung 12, die durch deren unterschiedliche Materialien bedingt sind, kompensiert oder zumindest deutlich vermindert werden, sodass zwischen den beiden Komponenten keine wärmeabhängigen Verspannungen und Verformungen entstehen.

Die Nachgiebigkeit der zweiten Klebeschichten 30 vermindert jedoch die Übertragung der kleinen Betätigungswege von der Deckschicht 28 auf die Sensorfelder 26 der Piezofolien 24 und wirkt so der eigentlichen Schaltfunktion der Drucktastschalter entgegen. Während in der älteren deutschen Patentanmeldung Nr. 10 2007 054 778.3 diesem Nachteil dadurch entgegengewirkt wird, dass im Bereich eines Sensorfeldes 26 jeweils ein Kraftübertragungselement zwischen der Piezofolie 22 und der Deckschicht 28 angeordnet ist, das in einer entsprechenden Aussparung der zweiten Klebeschicht 30 platziert ist und die Druckkräfte von der als Betätigungsfläche dienenden Deckschicht 28 auf die druckempfindliche Piezofolie 22 überträgt, ist gemäß der vorliegenden Erfindung eine spezielle zweite Klebeschicht 30 vorgesehen, durch welche auf die zusätzlichen Kraftübertragungselemente verzichtet werden kann.

Wie in der Draufsicht von Fig. 5 veranschaulicht, weist die zweite Klebeschicht 30 im Bereich eines entsprechenden Sensorfeldes 26 der darunter liegenden Piezofolie 22 einen Klebeschichtbereich 42 auf, der von der übrigen zweiten Klebeschicht 30 durch zwei Aussparungen 44a, 44b getrennt ist. Dieser Sensorfeld-Klebeschichtbereich 42 ist dabei deutlich kleiner bemessen als das jeweilige Sensorfeld 26 der Piezofolie 22. Die zum Beispiel im Wesentlichem punktförmigen Klebeschichtbereiche 42 sind dabei vorzugsweise ein integraler Bestandteil der zweiten Klebeschicht 30. Auch die Aussparungen 44a, 44b liegen noch im Bereich des Sensorfeldes 26 der Piezofolie 22.

In diesem Ausführungsbeispiel ist der Sensorfeld-Klebeschichtbereich 42 jeweils im Wesentlichen mittig zum jeweiligen Piezofolien-Sensorfeld 26 angeordnet und die zwei Aussparungen 44a, 44b sind im Wesentlichen ringförmig um den mittigen Sensorfeld-Klebeschichtbereich 42 herum angeordnet. Grundsätzlich ist es natürlich auch möglich, den Klebeschichtbereich 42 außermittig anzuordnen, mehr als nur einen Klebeschichtbereich 42 für ein Piezofolien-Sensorfeld 26 vorzusehen, nur eine oder mehr als zwei Aussparungen 44a, 44b um den Klebeschichtbereich 42 herum anzuordnen und/oder andere Größen / Formen / Anordnungen der Klebeschichtbereiche 42 und/oder der Aussparungen 44a, 44b zu wählen.

Wie erwähnt, vermindert die nachgiebige zweite Klebeschicht 30 eigentlich die Übertragung der sehr kleinen Betätigungswege der Deckschicht 28 auf die Sensorfelder 26 der Piezofolien 22. Um dennoch die Drucktastenfunktion sicherzustellen, sind die zweiten Klebeschichten 30 in der oben beschriebenen Weise ausgebildet. Die Aussparungen 44a, 44b vermindern dabei die dämpfende Wirkung der nachgiebigen zweiten Klebeschicht 30, sodass die Wegübertragung von der Deckschicht 28 auf die Sensorfelder 26 der Piezofolien 22 direkter erfolgen kann. Ein separates, starr bzw. unnachgiebig ausgebildetes Kraft- bzw. Wegübertragungselement ist deshalb bei dieser Ausführungsform der zweiten Klebeschichten 30 nicht erforderlich.

Außerdem ist die Deckschicht 28 über den mittigen Klebeschichtbereich 42 der zweiten Klebeschicht 30 unmittelbar mit dem jeweiligen Sensorfeld 26 der Piezofolie 22 verbunden, sodass die Piezofolie 22 direkt und beidseitig dem Betätigungsweg der Deckschicht 28 folgen kann. Die Wegübertragung ist damit unabhängig von einer Vorspannung der Piezo(sensor)folien 22.

Insbesondere können für die Bedienvorrichtung 12 der Erfindung gedruckte Piezofolien 22 mit einer beidseitigen Verklebung 24, 30 benutzt werden.

Wie in Fig. 1 dargestellt, kann die Bedienvorrichtung 12 neben den beiden Eingabebereichen 14, in denen jeweils eine Piezofolie 22 zur Ausbildung der mehreren Drucktastschalter angeordnet ist, auch über einen Anzeigebereich 16 verfügen. In diesem Anzeigebereich 16 kann an der dem Benutzer abgewandten Seite des Trägerelements 20 ein Anzeigeelement zum Beispiel in der Form eines Displays mit einer 7-Segmentanzeige angeordnet sein und auf der dem Benutzer zugewandten Seite des Trägerelements 20 zum Beispiel eine bedruckte Anzeigenabdeckung 34 aus Kunststoff (beispielsweise PMMA) auf das Trägerelement 20 geklebt sein. Das Anzeigeelement kann wahlweise auch nur einzelne Leuchtdioden aufweisen.

In dem Ausführungsbeispiel von Fig. 2 bis 5 enthält die Bedienvorrichtung 12 zwei Eingabebereiche 14 mit Drucktastschaltern, die vorliegende Erfindung ist aber nicht nur auf diese Ausführungsform beschränkt. Beispielsweise kann die Bedienvorrichtung 12 auch nur einen Eingabebereich 14 oder mehr als zwei Eingabebereiche 14 enthalten, mehrere Eingabebereiche 14 können wahlweise nebeneinander und/oder hintereinander angeordnet sein. Zusätzlich zu dem bzw. den Eingabebereich(en) können auch ein oder mehrere Anzeigebereiche 16 in der Bedienvorrichtung 12 vorhanden sein. Auch ist die Anzahl der Drucktastschalter in einem Eingabebereich 14 bzw. die Anzahl der Sensorfelder 26 auf einer Piezofolie 22 nicht speziell eingeschränkt. Ferner muss nicht jedem Sensorfeld 26 der Piezofolie 22 notwendigerweise ein Drucktastschalter zugeordnet sein, sodass zum Beispiel für mehrere Arten und Modelle eines Haushaltsgeräts mit unterschiedlichen Eingabebereichen 14 jeweils die gleichen Piezofolien 22 verwendet werden können.

In diesem Ausführungsbeispiel sind die Piezofolien 22 sowie die erste und die zweite Klebeschicht 24, 30 entsprechend den zwei Eingabebereichen 14 zweiteilig ausgebildet, während die Deckschicht 28 einteilig ausgebildet ist. Es ist ebenso möglich, auch die Piezofolien 22 und die Klebeschichten 24, 30 einteilig auszubilden und/oder die Deckschicht 28 zweiteilig auszubilden. Ferner können die Piezofolien 22, Klebeschichten 24, 30 und Deckschichten 28 wahlweise auch mehr als zwei Teilbereiche aufweisen, insbesondere dann, wenn mehrere Eingabereiche 14 und/oder auch wenigstens ein Anzeigebereich 16 vorgesehen sind.

### BEZUGSZIFFERNLISTE

- 10: Bedienblende
- 12: Bedienvorrichtung
- 14: Eingabebereich
- 16: Anzeigebereich
- 18: elektronische Steuerung
- 20: Trägerelement
- 22: Übertragungselement
- 24: erste Klebeschicht
- 26: Sensorfeld
- 28: Deckschicht
- 30: zweite Klebeschicht
- 32: Leiterplatte
- 34: Verbindungskabel
- 36: Stecker
- 38: dritte Klebeschicht
- 40: Rastvorrichtung
- 42: Sensorfeld-Klebeschichtbereich
- 44: Aussparung(en)

## Patentansprüche

1. Bedienvorrichtung (12) mit mehreren Drucktastschaltern, wobei die Bedienvorrichtung aufweist:
ein Trägerelement (20);
ein druckempfindliches Übertragungselement (22) mit mehreren Sensorfeldern (26) entsprechend den Drucktastschaltern, wobei das Übertragungselement (22) mit dem Trägerelement (20) über eine erste Klebeschicht (24) verbunden ist; und
eine der Benutzerseite zugewandte Deckschicht (28), wobei die Deckschicht (28) über eine zweite Klebeschicht (30) mit dem Übertragungselement (22) verbunden ist, wobei diese zweite Klebeschicht (30) weich ausgebildet ist und im Bereich der Sensorfelder (26) des Übertragungselements (22) jeweils einen Klebeschichtbereich (42) aufweist, der kleiner als das jeweilige Sensorfeld (26) bemessen ist und über wenigstens eine Aussparung (44a, 44b) im Bereich des jeweiligen Sensorfeldes (26) von der übrigen zweiten Klebeschicht (30) wenigstens teilweise getrennt ist.

2. Bedienvorrichtung nach Anspruch 1,
**dadurch gekennzeichnet,**
**dass** der Sensorfeld-Klebeschichtbereich (42) im Wesentlichen mittig zum jeweiligen Sensorfeld (26) des Übertragungselements (22) angeordnet ist.

3. Bedienvorrichtung nach Anspruch 1 oder 2,
**dadurch gekennzeichnet,**
**dass** die wenigstens eine Aussparung (44a, 44b) der zweiten Klebeschicht (30) den Sensorfeld-Klebeschichtbereich (42) im Wesentlichen ringförmig umgibt.

4. Bedienvorrichtung nach einem der vorherigen Ansprüche,
**dadurch gekennzeichnet,**
**dass** das Trägerelement (20) auf seiner dem Übertragungselement (22) abgewandten Seite eine Aussparung aufweist; und
**dass** die Bedienvorrichtung (12) ferner eine Leiterplatte (32) aufweist, die in die Aussparung des Trägerelements (20) eingesetzt ist.

5. Bedienvorrichtung nach Anspruch 4,
**dadurch gekennzeichnet,**
**dass** die Leiterplatte (32) in der Aussparung des Trägerelements (20) im Wesentlichen vollständig aufgenommen ist.

6. Bedienvorrichtung nach einem der vorherigen Ansprüche,
**dadurch gekennzeichnet,**
**dass** die Bedienvorrichtung (12) wenigstens ein Befestigungselement (38, 40) zum Befestigen der Bedienvorrichtung (12) an einer Bedienblende (10) aufweist.

7. Bedienvorrichtung nach Anspruch 6,
**dadurch gekennzeichnet,**
**dass** das wenigstens eine Befestigungselement eine dritte Klebeschicht (38) enthält.

8. Bedienvorrichtung nach Anspruch 6 oder 7,
**dadurch gekennzeichnet,**
**dass** das wenigstens eine Befestigungselement eine Rastvorrichtung (40) enthält.

9. Bedienvorrichtung nach einem der vorhergehenden Ansprüche,
**dadurch gekennzeichnet,**
**dass** das druckempfindliche Übertragungselement (22) ein Piezoelement, eine Piezofolie oder ein Dehnungsmessstreifen ist.

10. Elektronisches Haushaltsgerät mit einer Bedienblende (10) und einer in die Bedienblende eingesetzten Bedienvorrichtung (12) nach einem der Ansprüche 1 bis 9.

## Claims

1. Operator control apparatus (12) having a plurality of pushbutton switches, with the operator control apparatus having:
a support element (20);
a pressure-sensitive transmission element (22) having a plurality of sensor areas (26) which correspond to the pushbutton switches, with the transmission element (22) being connected to the support element (20) by means of a first adhesive layer (24), and
a covering layer (28) which faces the user side, with the covering layer (28) being connected to the transmission element (22) by means of a second adhesive layer (30), with this second adhesive layer (30) being soft and having in each case an adhesive layer region (42) in the region of the sensor areas (26) of the transmission element (22), the said adhesive layer region being smaller than the respective sensor area (26) and being at least partially separated from the rest of the second adhesive layer (30) by means of at least one cutout (44a, 44b) in the region of the respective sensor area (26).

2. Operator control apparatus according to Claim 1,
**characterized**
**in that** the sensor area adhesive layer region (42) is arranged substantially centrally in relation to the respective sensor area (26) of the transmission element (22).

3. Operator control apparatus according to Claim 1 or 2,
**characterized**
**in that** the at least one cutout (44a, 44b) of the second adhesive layer (30) substantially annularly surrounds the sensor area adhesive layer region (42).

4. Operator control apparatus according to one of the preceding claims,
**characterized**
**in that** the support element (20) has a cutout on that side which is averted from the transmission element (22); and
**in that** the operator control apparatus (12) also has a printed circuit board (32) which is inserted into the cutout in the support element (20).

5. Operator control apparatus according to Claim 4,
**characterized**
**in that** the printed circuit board (32) is substantially fully accommodated in the cutout in the support element (20).

6. Operator control apparatus according to one of the preceding claims,
**characterized**
**in that** the operator control apparatus (12) has at least one fixing element (38, 40) for fixing the operator control apparatus (12) to an operator control panel (10).

7. Operator control apparatus according to Claim 6,
**characterized**
**in that** the at least one fixing element contains a third adhesive layer (38).

8. Operator control apparatus according to Claim 6 or 7,
**characterized**
**in that** the at least one fixing element contains a latching apparatus (40).

9. Operator control apparatus according to one of the preceding claims,
**characterized**
**in that** the pressure-sensitive transmission element (22) is a piezo element, a piezo film or a strain gauge.

10. Electronic domestic appliance having an operator control panel (10) and an operator control apparatus (12), which is inserted into the operator control panel, according to one of Claims 1 to 9.

## Revendications

1. Dispositif de commande (12) avec plusieurs interrupteurs à pression, le dispositif de commande comportant :
un élément de support (20) ;
un élément de transmission (22) sensible à la pression avec plusieurs champs de capteurs (26) correspondant aux interrupteurs à pression, l'élément de transmission (22) étant relié à l'élément de support (20) par le biais d'une première couche de colle (24) ; et
une couche de revêtement (28) orientée vers le côté utilisateur, la couche de revêtement (28) étant reliée à l'élément de transmission (22) par le biais d'une deuxième couche de colle (30), cette deuxième couche de colle (30) étant réalisée de façon souple et comportant dans la zone des champs de capteurs (26) de l'élément de transmission (22) respectivement une zone de couche de colle (42) plus petite que le champ de capteurs (26) respectif et étant séparée de la deuxième couche de colle (30) restante au moins en partie par le biais d'au moins un évidement (44a, 44b) prévu dans la zone du champ de capteurs (26) respectif.

2. Dispositif de commande selon la revendication 1, **caractérisé en ce que** la zone de couche de colle du champ de capteurs (42) est disposée pour l'essentiel au centre du champ de capteurs (26) respectif de l'élément de transmission (22).

3. Dispositif de commande selon la revendication 1 ou 2, **caractérisé en ce que** l'au moins un évidement (44a, 44b) de la deuxième couche de colle (30) entoure la zone de couche de colle du champ de capteurs (42) pour l'essentiel selon une forme annulaire.

4. Dispositif de commande selon l'une quelconque des revendications précédentes, **caractérisé en ce que** :
l'élément de support (20) comporte un évidement sur le côté opposé à l'élément de transmission (22) ; et
le dispositif de commande (12) comporte en outre une plaque conductrice (32) insérée dans l'évidement de l'élément de support (20).

5. Dispositif de commande selon la revendication 4, **caractérisé en ce que** la plaque conductrice (32) est logée pour l'essentiel entièrement dans l'évidement de l'élément de support (20).

6. Dispositif de commande selon l'une quelconque des revendications précédentes, **caractérisé en ce que** le dispositif de commande (12) comporte au moins un élément de fixation (38, 40) servant à fixer le dispositif de commande (12) à un écran de commande (10) .

7. Dispositif de commande selon la revendication 6, **caractérisé en ce que** l'au moins un élément de fixation contient une troisième couche de colle (38).

8. Dispositif de commande selon la revendication 6 ou 7, **caractérisé en ce que** l'au moins un élément de fixation contient un dispositif d'encliquetage (40).

9. Dispositif de commande selon l'une quelconque des revendications précédentes, **caractérisé en ce que** l'élément de transmission (22) sensible à la pression est un élément piézoélectrique, un film piézoélectrique ou une bande de mesure de la dilatation.

10. Appareil électroménager électronique doté d'un écran de commande (10) et d'un dispositif de commande (12) selon l'une quelconque des revendications 1 à 9 disposé à l'intérieur de l'écran d'utilisation.
